# EUROPEAN PATENT APPLICATION

(11) **EP 3 731 261 A1**
(43) Date of publication of application: **28.10.2020**
(21) Application number: 18892121.7
(22) Date of filing: 19.12.2018
(51) Int. Cl.: H01L 21/304, B24B 37/00, C09K 3/14

(54) **COMPOSITION FOR POLISHING FOR USE IN ELIMINATING PROTRUSION IN PERIPHERY OF LASER MARK**

(30) Priority: 22.12.2017 JP 2017246934
(71) Applicant: Nissan Chemical Corporation, Tokyo 103-6119 (JP)
(72) Inventor: ISHIMIZU, Eiichiro, Funabashi-shi, Chiba 274-0052 (JP); TANATSUGU, Yusuke, Funabashi-shi, Chiba 274-0052 (JP)
(74) Representative: Hoffmann Eitle
(86) International application number: PCT/JP2018/046797
(87) International publication number: WO 2019/124442

(57) **Abstract**

There is provided a polishing composition used in a wafer polishing process for eliminating a protrusion around a laser mark, and a polishing method using the polishing composition.

A polishing composition for eliminating a protrusion around a laser mark on a laser mark-provided wafer, the polishing composition comprising a water-soluble compound, a chelating agent, and metal oxide particles, and having a pH of 7 to 12, wherein the water-soluble compound has a hydrophobic moiety and a hydrophilic moiety; the hydrophilic moiety has, on an end or side chain thereof, a hydroxyl group and a hydroxyethyl group, an acyloxy group, a carboxylic acid group, a carboxylic acid salt group, a sulfonic acid group, or a sulfonic acid salt group; and the water-soluble compound is contained in an amount of 5 to 700 ppm in the polishing composition.

The metal oxide particles are silica particles, zirconia particles, or ceria particles contained in a colloidal sol and having an average primary particle diameter of 5 to 100 nm. A wafer polishing method for polishing a protrusion around a laser mark.

## Description

### TECHNICAL FIELD

The present invention relates to a polishing composition used for polishing the surface of a wafer. Particularly, the present invention relates to a polishing composition used in a wafer polishing process for achieving a flat polished surface having no level difference at the periphery of a wafer (which may be referred to as, for example, "laser mark portion").

### BACKGROUND ART

A silicon wafer used for a semiconductor product is finished to have a mirror surface by a lapping process (rough grinding process) and a polishing process (precise polishing process). The polishing process includes a preliminary polishing process and a final polishing process.

For the purpose of, for example, identification, a silicon wafer may be provided with a mark (laser mark) such as a barcode, a numeral, or a symbol by irradiating the surface of the silicon wafer with laser light. In general, a silicon substrate is provided with such a laser mark after completion of a lapping process for the substrate and before initiation of a polishing process therefor. The laser light irradiation for providing the laser mark generally causes a protrusion (bump) on the silicon wafer surface around the laser mark. The laser mark portion of the silicon wafer is not used for a final product. However, when the aforementioned protrusion is not appropriately eliminated in the polishing process after provision of the laser mark, the yield of the product may be reduced to a level lower than expected. Thus, it is desired to appropriately eliminate the protrusion around the laser mark in a preliminary polishing process.

The phrase "elimination of a protrusion around a laser mark" as used herein refers to a decrease in the peak height of a protrusion as measured from a reference plane (horizontal plane) around a laser mark of a wafer.

### Prior Art Documents

### Patent Documents

Patent Document 1: International Publication WO 2015/019706 Pamphlet
Patent Document 2: International Publication WO 2017/110315 Pamphlet
Patent Document 3: Japanese Unexamined Patent Application Publication No. 2017-183359 (JP 2017-183359 A)

### SUMMARY OF THE INVENTION

### Problems to be Solved by the Invention

An object of the present invention is to provide a polishing composition used in a wafer polishing process for eliminating a protrusion around a laser mark, thereby achieving a flat polished surface, as well as a wafer polishing method using the polishing composition.

### Means for Solving the Problems

A first aspect of the present invention is a polishing composition for eliminating a protrusion around a laser mark on a laser mark-provided wafer, the polishing composition comprising a water-soluble compound, a chelating agent, and metal oxide particles, and having a pH of 7 to 12, wherein the water-soluble compound has a hydrophobic moiety and a hydrophilic moiety; the hydrophilic moiety has, on an end or side chain thereof, a hydroxyl group and a hydroxyalkyl group, an acyloxy group, a carboxylic acid group, a carboxylic acid salt group, a sulfonic acid group, or a sulfonic acid salt group; and the water-soluble compound is contained in an amount of 5 to 700 ppm in the polishing composition.

A second aspect of the present invention is the polishing composition according to the first aspect, wherein the metal oxide particles are silica particles, zirconia particles, or ceria particles having an average primary particle diameter of 5 to 100 nm.

A third aspect of the present invention is the polishing composition according to the first aspect, wherein the hydrophobic moiety of the water-soluble compound has a glucose structure, an alkylene group, an alkylene oxide group, or a repeating unit of any of these.

A fourth aspect of the present invention is the polishing composition according to any one of the first to third aspects, wherein the water-soluble compound is a compound having a unit structure of the following Formula (1), (2), or (3): 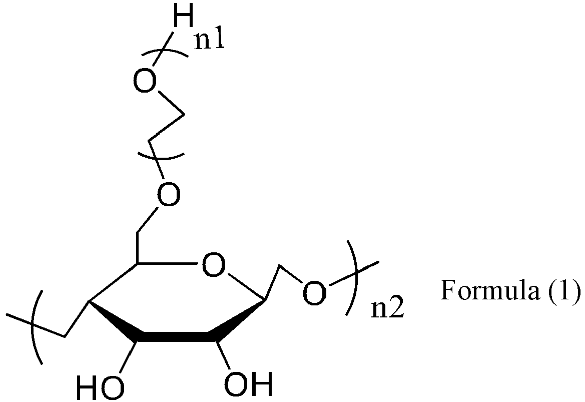 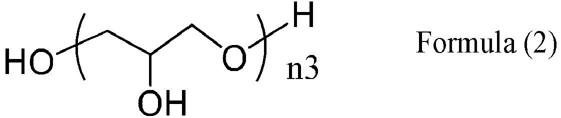 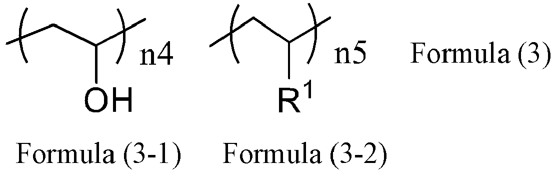 (wherein n1 is an integer of 1 to 5; n2 is an integer of 100 to 10,000; n3 is an integer of 1 to 30; R¹ is a -OCOCH₃ group, a -COOH group, a -COOM group, a -SO₃H group, or a - SO₃M group; M is Na, K, or NH₄; and n4 + n5, which is the sum of the number n4 of unit structures of Formula (3-1) and the number n5 of unit structures of Formula (3-2), is an integer of 100 to 10,000).

A fifth aspect of the present invention is the polishing composition according to any one of the first to fourth aspects, wherein the chelating agent is an aminocarboxylic acid chelating agent or a phosphonic acid chelating agent.

A sixth aspect of the present invention is the polishing composition according to any one of the first to fifth aspects, wherein the aminocarboxylic acid chelating agent is ethylenediaminetetraacetic acid, nitrilotriacetic acid, diethylenetriaminepentaacetic acid, hydroxyethylethylenediaminetriacetic acid, triethylenetetraminehexaacetic acid, 1,3-propanediaminetetraacetic acid, 1,3-diamine-2-hydroxypropanetetraacetic acid, hydroxyethyliminodiacetic acid, dihydroxyethylglycine, glycol ether diaminetetraacetic acid, dicarboxymethylglutamic acid, or ethylenediamine-N,N'-disuccinic acid.

A seventh aspect of the present invention is the polishing composition according to any one of the first to fifth aspects, wherein the phosphonic acid chelating agent is hydroxyethylidenediphosphonic acid, nitrilotris(methylenephosphonic acid), phosphonobutanetricarboxylic acid, or ethylenediaminetetra(methylenephosphonic acid).

An eighth aspect of the present invention is the polishing composition according to any one of the first to seventh aspects, wherein the polishing composition further comprises, as an alkaline component, ammonium hydroxide, primary ammonium hydroxide, secondary ammonium hydroxide, tertiary ammonium hydroxide, quaternary ammonium hydroxide, lithium carbonate, sodium carbonate, potassium carbonate, lithium hydrogen carbonate, sodium hydrogen carbonate, potassium hydrogen carbonate, sodium hydroxide, or potassium hydroxide.

A ninth aspect of the present invention is a wafer polishing method comprising a step of polishing a protrusion around a laser mark on a laser mark-provided wafer by using the polishing composition according to any one of the first to eighth aspects.

A tenth aspect of the present invention is a wafer polishing method comprising a step of preliminarily polishing a laser mark-provided wafer, and a step of polishing a protrusion around a laser mark on the laser mark-provided wafer by using the polishing composition according to any one of the first to eighth aspects.

An eleventh aspect of the present invention is the wafer polishing method according to the ninth or tenth aspect, wherein the protrusion polishing step is a step of polishing a laser-mark-around protrusion having a height of 50 nm to 500 nm as measured from a horizontal plane of the surface of the laser mark-provided wafer so that the protrusion has a height of 30 nm to -10 nm as measured from the horizontal plane.

### Effects of the Invention

The polishing composition of the present invention is used in a wafer polishing process for the purpose of eliminating a protrusion around a laser mark provided at the periphery of a wafer.

The polishing performance of the polishing composition largely depends on components of the composition other than silica particles and water.

A protrusion around a laser mark has wettability higher than that of other portions. Thus, in order to achieve efficient contact between the protrusion and a polishing component, the polishing composition is required to contain, as an additive, a water-soluble compound having an appropriate balance between hydrophilicity and hydrophobicity. The water-soluble compound is, for example, a compound, oligomer, and polymer having both a hydrophobic moiety and a hydrophilic moiety.

It has been found that, for example, a polymer substance having a hydrophobic central portion and a hydrophilic surrounding portion can efficiently bring a polishing component (e.g., silica particles, zirconia particles, and ceria particles) into contact with a protrusion around a laser mark.

For example, the incorporation of a polymer substance having a structure including a hydrophobic main chain and a hydrophilic end and/or side chain into the polishing composition enables efficient contact between a polishing component (e.g., silica particles, zirconia particles, and ceria particles) and a protrusion around a laser mark.

In a water-soluble compound such as a polymer having a hydrophilic moiety and a hydrophobic moiety, the hydrophilic moiety includes groups that include at least one hydroxyl group, and a hydroxyalkyl group, an acyloxy group, a carboxylic acid group, a carboxylic acid salt group, a sulfonic acid group, or a sulfonic acid salt group. The hydrophilic moiety of the water-soluble compound such as a polymer must have a hydroxyl group and another hydrophilic group. Because of the combination of these functional groups, the polishing composition of the present invention can achieve a good laser mark elimination ability. The combination of these functional groups is attributed to the modification of the polymer. The polymer modification can be achieved by substitution of a portion of the hydrogen atoms of hydroxymethyl groups with the aforementioned hydroxyethyl group or polyhydroxyalkyl group, or conversion of the hydrogen atom of a hydroxyl group into an acyl group (eventually, addition of an acyloxy group).

For example, the aforementioned combination of the functional groups can be achieved by modification of a portion of hydroxy groups of cellulose, polyvinyl alcohol, polyglycerin, etc. with any of the aforementioned other hydrophilic groups.

Also, the aforementioned combination of the functional groups can be achieved by copolymerization between vinyl alcohol and another vinyl-group-containing monomer having a carboxylic acid group or a sulfonic acid group. Such a carboxylic acid group or a sulfonic acid group can be converted into a carboxylic acid salt group or a sulfonic acid salt group by neutralization with an aqueous sodium hydroxide solution, an aqueous potassium hydroxide solution, or an aqueous ammonia solution.

In the hydrophilic moiety, the ratio between a hydroxyl group and a hydroxyalkyl group, an acyloxy group, a carboxylic acid group, a carboxylic acid salt group, a sulfonic acid group, or a sulfonic acid salt group can be represented by the ratio by mole of the latter to the former, and the ratio is increased by increasing the amount of the latter.

The polishing composition of the present invention can exhibit a good polishing performance even when the concentration of a polishing component or an additive is lower than that in a conventional polishing agent, since the polishing component (e.g., silica particles, zirconia particles, and ceria particles) can efficiently come into contact with a protrusion around a laser mark. The polishing composition of the present invention contains the polishing component at a low concentration, and thus exhibits a relatively low polishing resistance and can reduce occurrence of scratches on a polished surface.

### MODES FOR CARRYING OUT THE INVENTION

The present invention is directed to a polishing composition for eliminating a protrusion around a laser mark on a laser mark-provided wafer, the polishing composition comprising a water-soluble compound, a chelating agent, and metal oxide particles, and having a pH of 7 to 12, wherein the water-soluble compound has a hydrophobic moiety and a hydrophilic moiety; the hydrophilic moiety has, on an end or side chain thereof, a hydroxyl group and a hydroxyethyl group, an acyloxy group, a carboxylic acid group, a carboxylic acid salt group, a sulfonic acid group, or a sulfonic acid salt group; and the water-soluble compound is contained in an amount of 5 to 700 ppm or 10 to 500 ppm in the polishing composition.

The aforementioned phrase "the hydrophilic moiety has, on an end or side chain thereof, a hydroxyl group and a hydroxyalkyl group, an acyloxy group, a carboxylic acid group, a carboxylic acid salt group, a sulfonic acid group, or a sulfonic acid salt group" refers to the case where a hydroxyl group and a hydroxyalkyl group, an acyloxy group, a carboxylic acid group, a carboxylic acid salt group, a sulfonic acid group, or a sulfonic acid salt group are present on an end or side chain portion of the water-soluble compound to serve as hydrophilic groups. The compound having a unit structure of Formula (3) preferably has, on a side chain thereof, a hydroxyl group and another hydrophilic group. In such a case, the end of the compound serves as a polymerization-terminating group.

The hydroxyalkyl group is, for example, a C₂₋₁₀ hydroxyalkyl group. Examples of the C₂₋₁₀ hydroxyalkyl group include hydroxyethyl group and hydroxypropyl group.

The aforementioned polishing composition may contain water and may be diluted to a desired concentration. The polishing composition may optionally contain a surfactant.

The metal oxide particles may be added, as is, to the polishing composition. Alternatively, the metal oxide particles may be added in the form of a colloidal sol in an aqueous medium, more preferably a colloidal sol in water. The polishing composition may be prepared by addition of another component to a colloidal sol of metal oxide fine particles. When coarse particles (e.g., 0.5 µm or more) are contained in the colloidal sol, the coarse particles are preferably removed by any known method, followed by use of the colloidal sol in the polishing composition.

The metal oxide particles are polishing particles, and are silica particles, zirconia particles, or ceria particles contained in a colloidal sol and having an average primary particle diameter of 5 to 100 nm. The metal oxide particles are based on such a metal oxide sol.

The aforementioned polishing composition has a solid content of 0.1 to 15% by mass. The term "solid content" as used herein corresponds to the amount of all components of the polishing composition, except for the amount of an aqueous medium. The aqueous medium is a liquid containing water as a main component, and may contain a hydrophilic organic solvent.

The metal oxide particles may be contained in the polishing composition in an amount of 0.1 to 10% by mass, or 0.1 to 5% by mass, or 0.1 to 1% by mass. The metal oxide particles are particularly preferably silica particles.

No particular limitation is imposed on the metal oxide particles used, and the metal oxide particles may be a commercially available product or may be produced by any known method. For example, metal oxide particles having an average primary particle diameter of 5 to 100 nm may be used. For example, the silica particles used may be in the form of an aqueous dispersion of silica particles having an average primary particle diameter of 5 to 100 nm. Such an aqueous dispersion is a silica sol, and the silica contained in the silica sol corresponds to the silica particles contained in the polishing composition of the present invention. The aqueous medium in the silica sol may be replaced with water contained in the polishing composition. The water contained in the polishing composition is derived from water in the silica sol, and may also contain water added as dilution water.

The silica particles used in the present invention are preferably colloidal silica having an average primary particle diameter of 5 to 100 nm as determined by the nitrogen adsorption method. Silica particles having an average primary particle diameter of less than 5 nm may cause a reduction in polishing rate, and the silica particles are likely to aggregate, resulting in poor stability of the resultant polishing composition. Silica particles having an average primary particle diameter of more than 100 nm are likely to generate scratches on the surface of a wafer, and may cause poor planarity of the polished surface.

The same shall apply to other metal oxide particles, such as zirconia particles and ceria particles.

When coarse particles having a diameter of 0.5 µm or more are contained in a silica sol prepared by dispersion of silica particles in an aqueous medium, the coarse particles are preferably removed. The same shall apply to a metal oxide sol prepared by dispersion of other metal oxide particles, such as zirconia particles and ceria particles. The coarse particles are removed by the forced precipitation method or the microfiltration method. The filter used for the microfiltration may be any of, for example, a depth filter, a pleated filter, a membrane filter, and a hollow fiber filter. The material of such a filter may be any of, for example, cotton, polypropylene, polystyrene, polysulfone, polyethersulfone, nylon, cellulose, and glass. The filtration accuracy of a filter is represented by absolute filtration accuracy (size of particles trapped 99.9% or more). The aforementioned metal oxide particles (e.g., silica particles) are preferably treated with a filter having an absolute filtration accuracy of 0.5 µm to 1.0 µm, from the viewpoint of production efficiency (e.g., treatment time or the degree of filter clogging).

The pH of an aqueous metal oxide sol (e.g., silica sol, zirconia sol, or ceria sol) may be adjusted with, for example, ammonia, and a polymer, a chelating agent, etc. may be added to the aqueous sol. The pH adjustment of the metal oxide sol may be performed before, after, or before and after addition of the compound (polymer) or the chelating agent.

The pH of the polishing composition of the present invention can be adjusted to fall within a range of 7 to 12, 9 to 12, or 9.5 to 11, or 10 to 11.

The alkaline component used for such pH adjustment may be an aqueous solution of, for example, sodium hydroxide, potassium hydroxide, ammonia, primary ammonium hydroxide, secondary ammonium hydroxide, tertiary ammonium hydroxide, quaternary ammonium hydroxide, an organic amine, or an alkali metal carbonate. In particular, an aqueous ammonia solution or an aqueous potassium hydroxide solution is preferably used.

Examples of the ammonium salt derived from ammonia include ammonium hydroxide, ammonium carbonate, and ammonium hydrogen carbonate. Of these, ammonium hydroxide is preferred.

Other examples of the ammonium salt derived from ammonia include quaternary ammonium salts, such as tetramethylammonium hydroxide, ethyltrimethylammonium hydroxide, diethyldimethylammonium hydroxide, triethylmethylammonium hydroxide, tetraethylammmonium hydroxide, tetramethylammonium chloride, and tetraethylammonium chloride.

Examples of the organic amine include methylamine, dimethylamine, trimethylamine, ethylamine, diethylamine, triethylamine, monoethanolamine, diethanolamine, triethanolamine, N-methylethanolamine, N-methyl-N,N-diethanolamine, N,N-dimethylethanolamine, N,N-diethylethanolamine, N,N-dibutylethanolamine, ethylenediamine, hexaethylenediamine, ethylethylenediamine, piperazine hexahydrate, anhydrous piperazine, N-methylpiperazine, hydroxyethylpiperazine, N-aminoethylpiperazine, 1,3 -propanediamine, N,N-dimethylethylenediamine, diethylenetriamine, monoisopropanolamine, diisopropanolamine, and triisopropanolamine. Of these, monoethanolamine, ethylenediamine, or piperazine is preferred.

Examples of the alkali metal carbonate include lithium carbonate, sodium carbonate, potassium carbonate, lithium hydrogen carbonate, sodium hydrogen carbonate, and potassium hydrogen carbonate. In particular, sodium carbonate or potassium carbonate is preferred.

Through the pH adjustment, an alkaline component can be incorporated into the polishing composition in an amount of 5 to 1,000 ppm or 10 to 500 ppm.

The average primary particle diameter of the metal oxide particles can also be measured by observation with a transmission electron microscope. The average primary particle diameter may be 5 to 100 nm or 5 to 80 nm.

The water-soluble compound used in the present invention has a hydrophobic moiety and a hydrophilic moiety. In the hydrophilic moiety, a hydroxyl group and a hydroxyethyl group, an acyloxy group, a carboxylic acid group, a carboxylic acid salt group, a sulfonic acid group, or a sulfonic acid salt group form the hydrophilic end or side chain of the compound.

No particular limitation is imposed on the hydrophobic moiety of the water-soluble compound. The hydrophobic moiety preferably has a glucose structure, an alkylene group, an alkylene oxide group, or a repeating unit of any of these.

The water-soluble compound having a repeating unit (unit structure) of Formula (1) is a polymer; specifically, hydroxyethyl cellulose. In Formula (1), n1 is an integer of 1 to 5, typically an integer of 2, and n2 is an integer of 100 to 10,000. Hydrophilicity can be imparted by substitution of the hydrogen atom of the hydroxyl group of the hydroxymethyl group extending from a glucose skeleton with a hydroxyethyl group mediated by an oxyethylene group. The hydrogen atoms of the hydroxyl groups of the hydroxymethyl groups extending from glucose skeletons may be partially or completely substituted. Preferably, 50% by mole or more of the entire hydrogen atoms are substituted.

The aforementioned hydroxyethyl cellulose may have an average molecular weight of 100,000 to 1,500,000, or 500,000 to 1,300,000, or 600,000 to 1,200,000. The hydroxyethyl cellulose used may be, for example, trade name SE-400 (average molecular weight: 600,000) available from Daicel FineChem Ltd. or trade name CF-X (average molecular weight: 1,200,000) available from Sumitomo Seika Chemicals Company, Limited. When such hydroxyethyl cellulose is contained in the polishing composition in an amount of 10 to 500 ppm or 10 to 100 ppm, the polishing composition exhibits good laser mark elimination ability.

The water-soluble compound having a repeating unit (unit structure) of Formula (2) is glycerin or polyglycerin. In Formula (2), n3 is an integer of 1 to 30.

Glycerin or polyglycerin has a structure including a hydroxyl group and a hydroxyethyl group or a hydroxypropyl group. For example, glycerin or polyglycerin may have a structure including a hydroxyl group and a hydroxypropyl group.

Hydrophilicity can be imparted by substitution of the hydrogen atom of the hydroxyl group at the end or side chain of a polyoxyalkylene skeleton with a hydroxyethyl or hydroxypropyl group mediated by an oxyalkylene group. The hydrogen atoms of the hydroxyl groups of polyoxyalkylene skeletons may be partially or completely substituted. Preferably, 50% by mole or more of the entire hydrogen atoms are substituted.

The aforementioned polyglycerin is, for example, trade name Polyglycerin #750 (average molecular weight: 750) available from Sakamoto Yakuhin Kogyo Co., Ltd.

When such polyglycerin is contained in the polishing composition in an amount of 10 to 500 ppm or 10 to 100 ppm, the polishing composition exhibits good laser mark elimination ability.

The water-soluble compound having a unit structure of Formula (3); i.e., the water-soluble compound having a repeating unit (unit structure) of any of Formulae (3-1) and (3-2) is a polymer; specifically, modified polyvinyl alcohol. In Formula (3-2), R¹ is an acetoxy group, a carboxylic acid group (carboxyl group), a carboxylic acid salt group, a sulfonic acid group, or a sulfonic acid salt group. Each of the carboxylic acid and the sulfonic acid can be neutralized with an aqueous solution of, for example, sodium hydroxide, potassium hydroxide, or ammonia, to thereby introduce a counter ion such as Na⁺, K⁺, or NH4⁺. An acetoxy group can be introduced into the alkylene skeleton by reaction of polyvinyl alcohol with acetic acid, and substitution of the hydrogen atom of the hydroxyl group with an acetyl group. A carboxylic acid group or a sulfonic acid group can be introduced by copolymerization of acrylic acid, methacrylic acid, or vinylsulfonic acid with vinyl alcohol. The copolymerization of acrylic acid, methacrylic acid, or vinylsulfonic acid with vinyl alcohol may be block copolymerization or random copolymerization. The carboxylic acid group or sulfonic acid group-introduced water-soluble compound having a unit structure of Formula (3) may also be prepared by copolymerization of acrylic acid, methacrylic acid, or vinylsulfonic acid with vinyl acetate, and then partial or complete hydrolysis of acetyl groups. The alkylene unit having a hydroxyl group (Formula (3-1)) and the alkylene unit having an acetoxy group, a carboxylic acid group (carboxyl group), a carboxylic acid salt group, a sulfonic acid group, or a sulfonic acid salt group of R¹ (Formula (3-2)) may be present in a block or random form. In general, a random copolymer is preferably used. In the modified polyvinyl alcohol of Formula (3), the sum of the number n4 of unit structures of Formula (3-1) and the number n5 of unit structures of Formula (3-2) (i.e., n4 + n5) may be an integer of 100 to 10,000.

Hydrophilicity can be imparted by conversion of the hydroxyl group at the side chain of a polyalkylene skeleton into an acetoxy group, a carboxylic acid group (carboxyl group), a carboxylic acid salt group, a sulfonic acid group, or a sulfonic acid salt group of R¹. The hydroxyl groups of polyalkylene skeletons may be partially or completely substituted. Preferably, 50% by mole or more of the entire hydroxyl groups are substituted.

Examples of the water-soluble compound (polymer) include acetoxy group-introduced polyvinyl alcohol (trade name: JP-03, average molecular weight: 15,000, available from JAPAN VAM & POVAL CO., LTD.), sulfonic acid salt group-introduced polyvinyl alcohol (trade name: L-3266, average molecular weight: 20,000, available from The Nippon Synthetic Chemical Industry Co., Ltd.), and carboxylic acid salt group-introduced polyvinyl alcohol (trade name: T-330, average molecular weight: 140,000, available from The Nippon Synthetic Chemical Industry Co., Ltd.). Particularly preferred are sulfonic acid salt group-introduced polyvinyl alcohol and carboxylic acid salt group-introduced polyvinyl alcohol.

When such polyvinyl alcohol is contained in the polishing composition in an amount of 10 to 500 ppm or 10 to 100 ppm, the polishing composition exhibits good laser mark elimination ability.

The polishing composition of the present invention may contain a chelating agent. Examples of the chelating agent include an aminocarboxylic acid chelating agent and a phosphonic acid chelating agent.

Examples of the aminocarboxylic acid chelating agent include ethylenediaminetetraacetic acid, nitrilotriacetic acid, diethylenetriaminepentaacetic acid, hydroxyethylethylenediaminetriacetic acid, triethylenetetraminehexaacetic acid, 1,3-propanediaminetetraacetic acid, 1,3-diamine-2-hydroxypropanetetraacetic acid, hydroxyethyliminodiacetic acid, dihydroxyethylglycine, glycol ether diaminetetraacetic acid, dicarboxymethylglutamic acid, and ethylenediamine-N,N'-disuccinic acid.

Examples of the phosphonic acid chelating agent include hydroxyethylidenediphosphonic acid, nitrilotris(methylenephosphonic acid), phosphonobutanetricarboxylic acid, and ethylenediaminetetra(methylenephosphonic acid).

The chelating agent may be contained in an amount of 0.005 to 1.0% by mass relative to the entire mass of the polishing composition of the present invention.

Examples of the wafer to which the wafer polishing composition of the present invention can be applied include silicon wafer, SiC wafer, GaN wafer, GaAs wafer, GaP wafer, glass wafer, aluminum wafer, and sapphire wafer.

The polishing apparatus used for polishing of the water is of a single-side polishing type or a double-side polishing type. The polishing composition of the present invention may be used in any of these types of apparatuses.

The use of the polishing composition of the present invention for a wafer polishing process can produce a wafer having a flat polished surface wherein the difference in level is small between the center of the wafer and the periphery (laser mark portion) of the wafer.

The polishing composition of the present invention can be used to polish a protrusion around a laser mark on a laser mark-provided wafer.

In the present invention, a step of preliminarily polishing a laser mark-provided wafer can be followed by a step of polishing a protrusion around a laser mark on the laser mark-provided wafer by using the polishing composition of the present invention.

Thus, a laser-mark-around protrusion having a height of 50 to 500 nm or 50 to 200 nm as measured from a horizontal plane of the surface of the laser mark-provided wafer can be polished so as to have a height of 30 nm to -10 nm, preferably 25 nm to 0 nm, more preferably 0 nm, as measured from the horizontal plane. A height of about -10 nm of the polished laser-mark-around protrusion corresponds to the state where the laser-mark-around protrusion is polished and scraped down toward a laser mark dent so as to have a height of about -10 nm. Such a negative value is due to polishing of the edge of the dent, and the height is ideally and preferably 0 nm.

### Examples

A commercially available silicon wafer was polished by a method described below.

### 1) Preparation of Composition Containing Chelating Agent and Metal Oxide Particles

Additives were added in proportions as shown in Table 1 below; specifically, colloidal silica (silica particles derived from silica sol) having an average primary particle diameter of 40 nm as determined by the nitrogen adsorption method (0.33% by mass), ammonium hydroxide serving as a basic compound (alkaline component) (25 ppm), sodium ethylenediaminetetraacetate (reagent) serving as a chelating agent (110 ppm), and water (balance), to thereby produce a composition (A) containing the chelating agent and the metal oxide particles.

Components were added in a manner similar to that of the composition (A), to thereby produce each composition. Specifically, compositions (B) to (J) were produced in the same manner as in the composition (A), except that the amount (% by mass) of colloidal silica (silica particles derived from silica sol) having an average primary particle diameter of 40 nm, the type and amount (ppm) of a basic substance, and the type and amount (ppm) of a chelating agent were varied as shown in Table 1 below.

In Table 1, EDTA denotes sodium ethylenediaminetetraacetate; NH₄OH, ammonium hydroxide; KOH, potassium hydroxide; and ETMAH, ethyltrimethylammonium hydroxide.

**Table 1**

| Composition | pH | Colloidal silica | Basic substance | Chelating agent |
|---|---|---|---|---|
| (A) | 10.1 | 0.33% by mass | NH₄OH 25 ppm | EDTA 110 ppm |
| (B) | 10.3 | 0.33% by mass | KOH 42 ppm | EDTA 110 ppm |
| (C) | 9.8 | 0.80% by mass | KOH 42 ppm | EDTA 110 ppm |
| (D) | 10.5 | 0.80% by mass | KOH 83 ppm | EDTA 110 ppm |
| (E) | 11.2 | 0.80% by mass | KOH 167 ppm | EDTA 110 ppm |
| (F) | 10.9 | 0.50% by mass | ETMAH 167 ppm | EDTA 110 ppm |
| (G) | 10.2 | 0.33% by mass | ETMAH 83 ppm | EDTA 110 ppm |
| (H) | 9.8 | 0.80% by mass | ETMAH 83 ppm | EDTA 110 ppm |
| (I) | 10.5 | 0.80% by mass | ETMAH 167 ppm | EDTA 110 ppm |
| (J) | 11.1 | 0.80% by mass | ETMAH 334ppm | EDTA 110 ppm |

### 2) Polishing Conditions

Polishing machine: double-side polishing machine 13BF, available from HAMAI CO., LTD.
Load: 150 g/cm²
Rotation speed of upper surface plate: 7 rpm
Rotation speed of lower surface plate: 20 rpm
Polishing pad: foamed polyurethane-made polishing pad
Feed rate of polishing diluent: 6.0 L/minute
Polishing time: 5 minutes
Silicon wafer: diameter: 200 mm, conduction type: P-type, crystal orientation <100>, resistivity: less than 100 Ω·cm

### 3) Washing Conditions

The wafer was washed with water, and then with SC1 cleaning solution (29% aqueous ammonia : 30% aqueous hydrogen peroxide : water = 1 : 1 : 28 by weight) heated at 40°C, to thereby remove impurities on the surface of the wafer.

### 4) Method of Measurement of Laser Mark Height

An optical interference microscope system BW-M7000 available from NIKON INSTECH CO., LTD. was used to measure the difference in height between the highest portion and the lowest portion on the surface of the wafer with respect to a roughness curve prepared by scanning of a constant width (500 µm).

### <Example 1>

To the above-prepared composition (A) was added hydroxyethyl cellulose (average molecular weight: 600,000, trade name: SE-400, available from Daicel FineChem Ltd.) serving as a water-soluble compound so that the amount thereof in a polishing composition was 100 ppm. Thus, a polishing composition of Example 1 was produced. A silicon wafer was polished with the polishing composition for five minutes. Subsequently, the silicon wafer was washed, and the height of a laser mark was measured. The height of a portion around the laser mark was 151 nm before the polishing, and the laser mark height was 0 nm after the polishing; i.e., a favorable result was obtained. The polishing rate was 0.06 µm/minute.

### <Examples 2 to 20 and Comparative Examples 1 to 5>

As shown in Table 2 below, a water-soluble compound was added to each composition in the same manner as in Example 1, to thereby prepare polishing compositions of Examples 2 to 20 and Comparative Examples 1 to 5. Table 2 shows the types of the aforementioned compositions used in the respective Examples and the types and concentration (ppm) of water-soluble compounds in the polishing compositions. The pH values of the polishing compositions of Examples 1 to 20 and Comparative Examples 1 to 5 are the same as those of the used compositions (A) to (J).

In Table 2, water-soluble compound (a) is hydroxyethyl cellulose (average molecular weight: 600,000, trade name: SE-400, available from Daicel FineChem Ltd.);
water-soluble compound (b) is hydroxyethyl cellulose (average molecular weight: 1,200,000, trade name: CF-X, available from Sumitomo Seika Chemicals Company, Limited);
water-soluble compound (c) is glycerin (trade name: Purified Glycerin, available from Sakamoto Yakuhin Kogyo Co., Ltd.);
water-soluble compound (d) is polyglycerin (average molecular weight: 750, trade name: Polyglycerin #750, available from Sakamoto Yakuhin Kogyo Co., Ltd.);
water-soluble compound (e) is sulfonic acid group-modified polyvinyl alcohol (average molecular weight: 20,000, trade name: L-3266, available from The Nippon Synthetic Chemical Industry Co., Ltd.);
water-soluble compound (f) is carboxyl group-modified polyvinyl alcohol (average molecular weight: 140,000, trade name: T-330, available from The Nippon Synthetic Chemical Industry Co., Ltd.);
water-soluble compound (g) is modified polyglycerin (polyoxyethylene polyglyceryl ether, trade name: SC-E1500, available from Sakamoto Yakuhin Kogyo Co., Ltd., prepared by conversion of the hydrogen atom of a hydroxyl group of polyglycerin into a hydroxyethyl group);
water-soluble compound (h) is modified polyglycerin (caprylic acid ester, trade name: MCA750, available from Sakamoto Yakuhin Kogyo Co., Ltd., prepared by reaction of a hydroxyl group of polyglycerin with caprylic acid);
water-soluble compound (i) is modified polyglycerin (polyoxypropylene polyglyceryl ether, trade name: SC-E1600, available from Sakamoto Yakuhin Kogyo Co., Ltd., prepared by conversion of the hydrogen atom of a hydroxyl group of polyglycerin into a 1-methylhydroxyethyl group); and
water-soluble compound (j) is polyvinyl alcohol (average molecular weight: 3,500, reagent).

**Table 2**

| | Composition | Water-soluble compound and Concentration |
|---|---|---|
| Example 1 | Composition (A) | Water-soluble compound (a) 100 ppm |
| Example 2 | Composition (A) | Water-soluble compound (b) 100 ppm |
| Example 3 | Composition (A) | Water-soluble compound (b) 10 ppm |
| Example 4 | Composition (A) | Water-soluble compound (c) 100 ppm |
| Example 5 | Composition (A) | Water-soluble compound (d) 100 ppm |
| Example 6 | Composition (A) | Water-soluble compound (d) 10 ppm |
| Example 7 | Composition (A) | Water-soluble compound (d) 500 ppm |
| Example 8 | Composition (A) | Water-soluble compound (e) 100 ppm |
| Example 9 | Composition (A) | Water-soluble compound (f) 100 ppm |
| Example 10 | Composition (B) | Water-soluble compound (f) 100 ppm |
| Example 11 | Composition (C) | Water-soluble compound (f) 100 ppm |
| Example 12 | Composition (D) | Water-soluble compound (f) 100 ppm |
| Example 13 | Composition (E) | Water-soluble compound (f) 100 ppm |
| Example 14 | Composition (F) | Water-soluble compound (f) 100 ppm |
| Example 15 | Composition (F) | Water-soluble compound (a) 100 ppm |
| Example 16 | Composition (F) | Water-soluble compound (e) 100 ppm |
| Example 17 | Composition (G) | Water-soluble compound (f) 100 ppm |
| Example 18 | Composition (H) | Water-soluble compound (f) 100 ppm |
| Example 19 | Composition (I) | Water-soluble compound (f) 100 ppm |
| Example 20 | Composition (J) | Water-soluble compound (f) 100 ppm |
| Comparative Example 1 | Composition (A) | No addition of water-soluble compound |
| Comparative Example 2 | Composition (A) | Water-soluble compound (g) 100 ppm |
| Comparative Example 3 | Composition (A) | Water-soluble compound (h) 100 ppm |
| Comparative Example 4 | Composition (A) | Water-soluble compound (i) 100 ppm |
| Comparative Example 5 | Composition (A) | Water-soluble compound (j) 100 ppm |

Table 3 shows the conditions and results of the polishing test in each of the Examples.

**Table 3**

| | Height of portion around laser mark | | Polishing time | Polishing rate |
|---|---|---|---|---|
| | Before test (nm) | After test (nm) | (minutes) | (µm/minute) |
| Example 1 | 151 nm | 0 nm to -5 nm | 5 | 0.06 |
| Example 2 | 156 nm | 0 nm to -5 nm | 5 | 0.05 |
| Example 3 | 141 nm | 0 nm to -5 nm | 5 | 0.10 |
| Example 4 | 92 nm | 18 nm | 5 | 0.03 |
| Example 5 | 158 nm | 21 nm | 5 | 0.01 |
| Example 6 | 109 nm | 13 nm | 5 | 0.03 |
| Example 7 | 92 nm | 24 nm | 5 | 0.01 |
| Example 8 | 159 nm | 0 nm to -5 nm | 5 | 0.01 |
| Example 9 | 117 nm | 0 nm to -5 nm | 5 | 0.01 |
| Example 10 | 141 nm | 0 nm to -5 nm | 5 | 0.03 |
| Example 11 | 104 nm | 0 nm to -5 nm | 5 | 0.04 |
| Example 12 | 182 nm | 0 nm to -5 nm | 5 | 0.09 |
| Example 13 | 184 nm | 0 nm to -5 nm | 5 | 0.09 |
| Example 14 | 132 nm | 0 nm to -5 nm | 5 | 0.05 |
| Example 15 | 117 nm | 0 nm to -5 nm | 5 | 0.05 |
| Example 16 | 135 nm | 0 nm to -5 nm | 5 | 0.03 |
| Example 17 | 158 nm | 0 nm to -5 nm | 5 | 0.03 |
| Example 18 | 181 nm | 0 nm to -5 nm | 5 | 0.02 |
| Example 19 | 160 nm | 0 nm to -5 nm | 5 | 0.15 |
| Example 20 | 168 nm | 0 nm to -5 nm | 5 | 0.07 |
| Comparative Example 1 | 105 nm | 43 nm | 5 | 0.03 |
| Comparative Example 2 | 155 nm | 95 nm | 5 | 0.03 |
| Comparative Example 3 | 133 nm | 57 nm | 5 | 0.01 |
| Comparative Example 4 | 126 nm | 46 nm | 5 | 0.01 |
| Comparative Example 5 | 93 nm | 45 nm | 5 | 0.01 |

The aforementioned polishing rate corresponds to the determined polishing rate of the silicon wafer. However, the value of the polishing rate on the silicon wafer does not necessarily relate to the degree of elimination (polishing) of a protrusion around the laser mark. Conceivably, the polishing of the protrusion around the laser mark is attributed to efficient contact between the protrusion and the polishing component resulting from contact between the protrusion and a hydrophilic moiety of the water-soluble compound. This suggests that the polishing composition for eliminating a protrusion around a laser mark cannot be expected from any conventionally known polishing composition for a silicon wafer.

### INDUSTRIAL APPLICABILITY

The use of the polishing composition of the present invention in a wafer polishing process can eliminate a protrusion around a laser mark, to thereby achieve a flat polished surface.

## Claims

1. A polishing composition for eliminating a protrusion around a laser mark on a laser mark-provided wafer, the polishing composition comprising a water-soluble compound, a chelating agent, and metal oxide particles, and having a pH of 7 to 12, wherein the water-soluble compound has a hydrophobic moiety and a hydrophilic moiety; the hydrophilic moiety has, on an end or side chain thereof, a hydroxyl group and a hydroxyalkyl group, an acyloxy group, a carboxylic acid group, a carboxylic acid salt group, a sulfonic acid group, or a sulfonic acid salt group; and the water-soluble compound is contained in an amount of 5 to 700 ppm in the polishing composition.

2. The polishing composition according to claim 1, wherein the metal oxide particles are silica particles, zirconia particles, or ceria particles having an average primary particle diameter of 5 to 100 nm.

3. The polishing composition according to claim 1, wherein the hydrophobic moiety of the water-soluble compound has a glucose structure, an alkylene group, an alkylene oxide group, or a repeating unit of any of these.

4. The polishing composition according to any one of claims 1 to 3, wherein the water-soluble compound is a compound having a unit structure of the following Formula (1), (2), or (3): 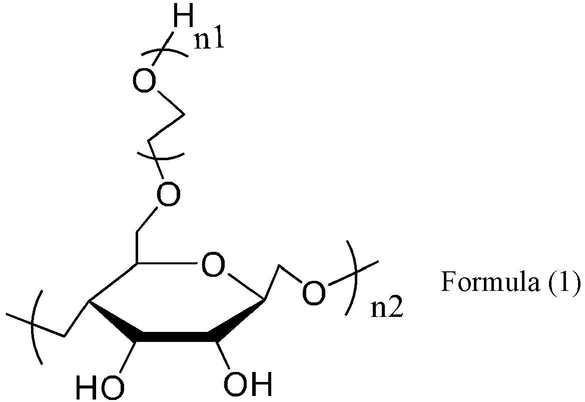 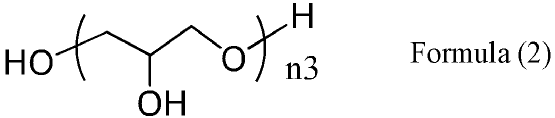 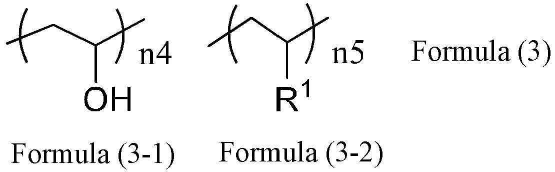 (wherein n1 is an integer of 1 to 5; n2 is an integer of 100 to 10,000; n3 is an integer of 1 to 30; R¹ is a -OCOCH₃ group, a -COOH group, a -COOM group, a -SO₃H group, or a - SO₃M group; M is Na, K, or NH₄; and n4 + n5, which is the sum of the number n4 of unit structures of Formula (3-1) and the number n5 of unit structures of Formula (3-2), is an integer of 100 to 10,000).

5. The polishing composition according to any one of claims 1 to 4, wherein the chelating agent is an aminocarboxylic acid chelating agent or a phosphonic acid chelating agent.

6. The polishing composition according to any one of claims 1 to 5, wherein the aminocarboxylic acid chelating agent is ethylenediaminetetraacetic acid, nitrilotriacetic acid, diethylenetriaminepentaacetic acid, hydroxyethylethylenediaminetriacetic acid, triethylenetetraminehexaacetic acid, 1,3-propanediaminetetraacetic acid, 1,3-diamine-2-hydroxypropanetetraacetic acid, hydroxyethyliminodiacetic acid, dihydroxyethylglycine, glycol ether diaminetetraacetic acid, dicarboxymethylglutamic acid, or ethylenediamine-N,N'-disuccinic acid.

7. The polishing composition according to any one of claims 1 to 5, wherein the phosphonic acid chelating agent is hydroxyethylidenediphosphonic acid, nitrilotris(methylenephosphonic acid), phosphonobutanetricarboxylic acid, or ethylenediaminetetra(methylenephosphonic acid).

8. The polishing composition according to any one of claims 1 to 7, wherein the polishing composition further comprises, as an alkaline component, ammonium hydroxide, primary ammonium hydroxide, secondary ammonium hydroxide, tertiary ammonium hydroxide, quaternary ammonium hydroxide, lithium carbonate, sodium carbonate, potassium carbonate, lithium hydrogen carbonate, sodium hydrogen carbonate, potassium hydrogen carbonate, sodium hydroxide, or potassium hydroxide.

9. A wafer polishing method comprising a step of polishing a protrusion around a laser mark on a laser mark-provided wafer by using the polishing composition according to any one of claims 1 to 8.

10. A wafer polishing method comprising a step of preliminarily polishing a laser mark-provided wafer, and a step of polishing a protrusion around a laser mark on the laser mark-provided wafer by using the polishing composition according to any one of claims 1 to 8.

11. The wafer polishing method according to claim 9 or 10, wherein the protrusion polishing step is a step of polishing a laser-mark-around protrusion having a height of 50 nm to 500 nm as measured from a horizontal plane of the surface of the laser mark-provided wafer so that the protrusion has a height of 30 nm to -10 nm as measured from the horizontal plane.
